# EUROPEAN PATENT APPLICATION

(11) **EP 1 643 552 A1**
(43) Date of publication of application: **05.04.2006**
(21) Application number: 04731753.2
(22) Date of filing: 07.05.2004
(51) Int. Cl.: H01L 25/00, H05K 3/46

(54) **MODULE INCLUDING CIRCUIT ELEMENTS**

(30) Priority: 09.05.2003 JP 2003132066
(71) Applicant: MATSUSHITA ELECTRIC INDUSTRIAL CO., LTD., Kadoma-shi, Osaka 571-8501 (JP)
(72) Inventor: HANDA, Hiroyuki, Osaka 573 (JP); NAKATANI, Seiichi, Osaka 573-0084 (JP); HIRANO, Koichi, Osaka 573-1146 (JP); INOUE, Osamu, Osaka 573-1105 (JP); ISHIKAWA, Akihiro, Osaka 572-0063 (JP); YOSHIDA, Tsunenori, Kyoto 614-8372 (JP)
(74) Representative: Dempster, Benjamin John Naftel
(86) International application number: PCT/JP2004/006496
(87) International publication number: WO 2004/100264

(57) **Abstract**

In a module (51) including circuit elements, a plurality of wires (12), which are generally two-dimensionally formed, are multi-layered via electrically insulating material (11), which comprises a mixture including at least filler and electrically insulating resin. One or more circuit elements are electrically connected to the wires, and at least a part of those circuit elements is embedded in the electrically insulating material. The module (51) further includes a heat sink member (13) that has a higher thermal conductivity than the electrically insulating material, and that, when viewed from the direction of multi-layering the wires, overlaps with a circuit element (14), which is one of those circuit elements, exhibiting the highest temperature rise at least in the module.

## Description

### Technical Field

The present invention relates to a module with built-in circuit elements for use in electronics devices and more particularly to a module with built-in circuit elements which contains circuit elements.

### Background Art

Conventional electronics devices contain various kinds of circuit modules. Such circuit modules are typically fabricated in the following way: A plurality of circuit elements (e.g., active elements such as transistors and ICs; and passive elements such as resistors and capacitors) are mounted on a substrate to form a specified electronic circuit and then, the mounted circuit elements as well as the substrate is entirely covered and sealed with an electrically insulating material such as epoxy resin. In the circuit modules thus formed, since the plurality of circuit elements are two-dimensionally mounted on the substrate with high density, the circuit modules themselves are small in size and therefore contribute to miniaturization and high performance of electronics devices. For this reason, the circuit modules have been heretofore suitably used for electronics devices and particularly for those required to be compact such as information terminal units (e.g., PDA (Personal Digital Assistance)) and cellular phones.

In recent years, there have been advanced the development of a module with built-in circuit elements which has a further improved density of packaging circuit elements. In this module with built-in circuit elements, the packaging density for the circuit elements is three-dimensionally increased by partially embedding the circuit elements in the substrate, which circuit elements are components of the circuit module. This module with built-in circuit elements is small, compared to the conventional circuit modules and therefore has the effect of enabling smaller electronics devices than those obtained when the circuit modules commonly used from before are mounted. This module with built-in circuit elements however has revealed such a problem that since the circuit elements are embedded in a resin having low thermal conductivity, the heat generated from the embedded circuit elements while the electronics device is in operation is accumulated within the module with built-in circuit elements. The accumulated heat sometimes affects the embedded circuit elements so that they are excessively heated. This results in the problem that if the temperature of the embedded circuit elements exceeds an allowable range, the embedded circuit elements will be damaged. Accordingly, there is a need to develop a module with built-in circuit elements having a structure in which the heat generated from the embedded circuit elements during the operation of the device is dissipated outwardly from the module with built-in circuit elements. As described below, there have been proposed various structures for outwardly releasing the heat generated from the embedded circuit elements while the device is in operation.

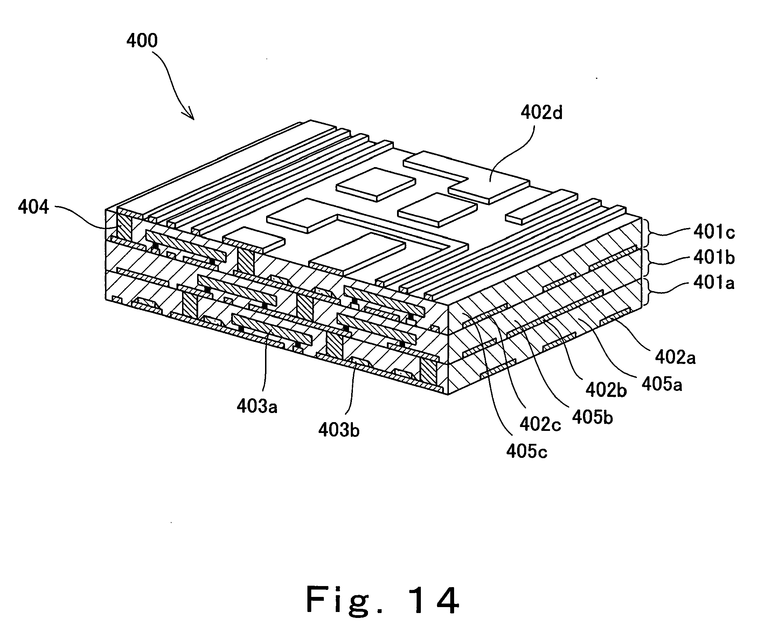

Fig. 14 is a perspective sectional view illustrating part of one example of the modules with built-in circuit elements having a structure for outwardly dissipating the heat generated from the embedded circuit elements.

The module with built-in circuit elements 400 shown in Fig. 14 is composed of substrates (layers) 401 a, 401 b, 401 c and wirings (wiring patterns) 402d. The substrates 401 a, 401 b, 401 c include wirings 402a, 402b, 402c respectively and electrically insulating materials 405a, 405b, 405c respectively. Embedded in each of the electrically insulating materials 405a, 405b, 405c are a circuit element 403a and/or a circuit element 403b. The circuit elements 403a, 403b are electrically connected to their associated wiring 402a, 402b, or 402c at a specified position thereon. The opposed pairs of wirings 401 a, 401 b, 401 c, 402d, that is, the wirings 402a and 402b; the wirings 402b and 402c; the wirings 402c and 402d are respectively, electrically interconnected by inner via holes 404. The inner via holes 404 are filled with an electrically conductive resin. This resin is electrically connected to the surfaces of the wirings 402a to 402d, thereby establishing electrical connection between the opposed pairs of wirings. In the module with built-in circuit elements 400 shown in Fig. 14, the electrically insulating materials 405a, 405b, 405c are made of a mixture of a thermosetting resin and an inorganic filler (70 to 95 wt%). Since the thermal conductivity of the inorganic filler is higher than that of the thermosetting resin, the thermal conductivity of the electrically insulating materials 405a, 405b, 405c is highly improved compared to the case the electrically insulating materials are made of the thermosetting resin alone. Therefore, the heat generated from the circuit elements 403a, 403b while the electronics device is in operation is transmitted from the circuit elements 403a, 403b to the electrically insulating materials 405a, 405b, 405c and then to the principal surface and side faces of the module with built-in circuit elements 400. As a result, most of the heat generated from the circuit elements 403a, 403b is dissipated outwardly from the principal surface and side faces of the module with built-in circuit elements 400 (e.g., Japanese Published Unexamined Application No. 11-220262).

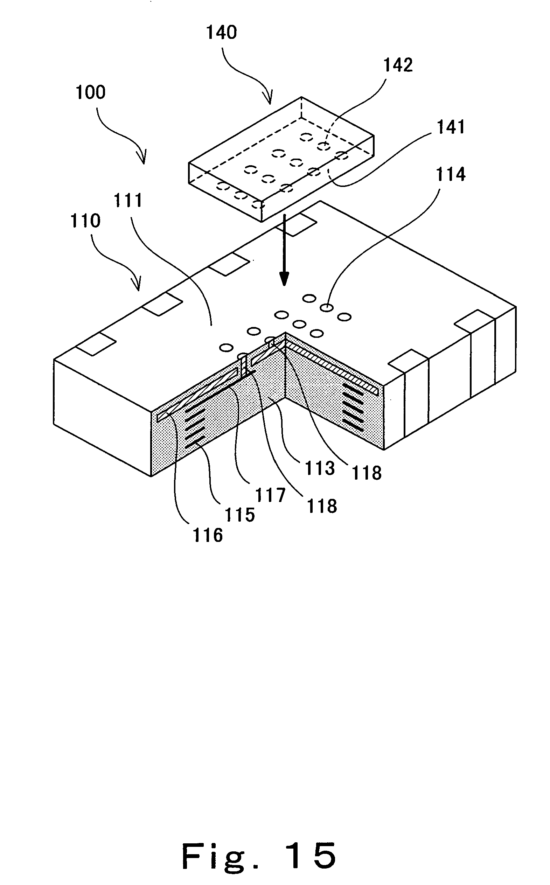

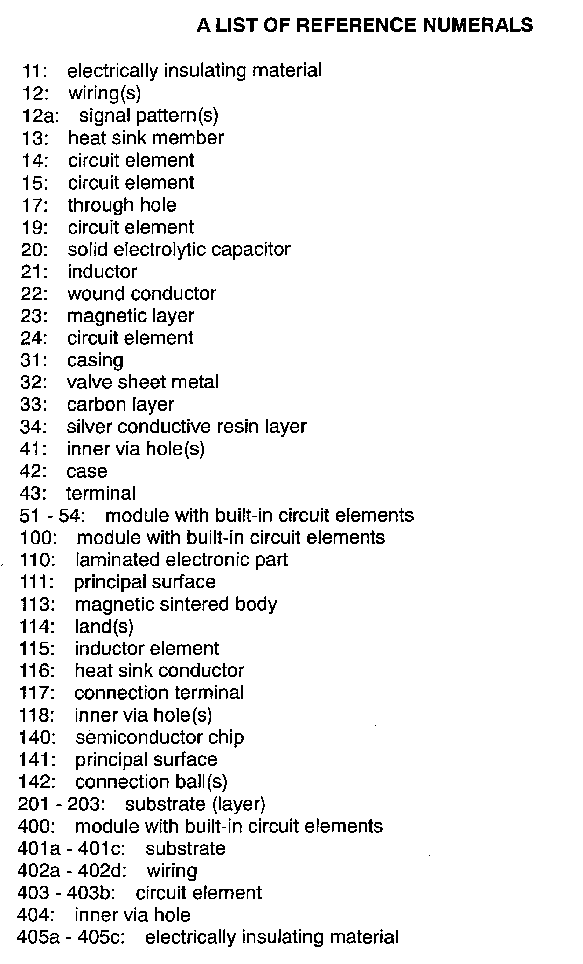

Fig. 15 is a perspective view illustrating one example of the modules with built-in circuit elements having a structure for outwardly dissipating the heat generated from the mounted circuit elements. The module with built-in circuit elements 100 shown in Fig. 15 is such that a laminated electronic part 110 (described later) and a semiconductor chip 140 mounted on the laminated electronic part 110 are separated from each other. The semiconductor chip 140 is perspectively shown. The laminated electronic part 110 is shown in a partially cut-away condition in order to clearly demonstrate its internal structure.

The module with built-in circuit elements 100 shown in Fig. 15 is composed of a laminated electronic part 110 and a semiconductor chip 140. The laminated electronic part 110 and the semiconductor chip 140 are integrated by electrically connecting a plurality of lands 114 formed on a principal surface 111 of the laminated electronic part 110 to a plurality of connection balls 142 formed on a principal surface 141 of the semiconductor chip 140 by a specified means. Electrically connected to the plurality of lands 114 formed on the principal surface 111 of the laminated electronic part 110 are one end of each inner via hole 118. The other end of each inner via hole 118 is electrically connected to a heat sink conductor 116 or a connection terminal 117 of an inductor element 115. The laminated electronic part 110 shown in Fig. 15 is formed by embedding the inner via holes 118, the heat sink conductor 116 and the inductor element 115 in a magnetic sintered body 113. In the module with built-in circuit elements 100 shown in Fig. 15, the heat sink conductor 116 is molded in rectangular form and embedded within the laminated electronic part 100 at a specified position close to the principal surface 111 such that the conductor 116 is substantially parallel to the principal surface 111 and at least one part of the conductor 116 is heat-conductive to the lands 114. Therefore, the heat generated from the semiconductor chip 140 is transmitted to the lands 114 by way of the connection balls 142 and further to the heat sink conductor 116 by way of the inner via holes 118. As a result, most of the heat generated from the semiconductor chip 140 is released outwardly from the principal surface 111 of the laminated electronic part 110 (e.g., Japanese Published Unexamined Application No. 2000-331835).

Recently, the power consumption of electronics devices tends to increase under the influence of the higher performance and higher functionality of electronics devices. As the power consumption of an electronics device increases, the amount of power dealt by the circuit module or module with built-in circuit elements, which is mounted on the electronics device, tends to increase. If the amount of power dealt by the circuit module or module with built-in circuit elements increases, exceeding those of the conventional modules, the current, which flows through the circuit elements mounted on or embedded in the circuit module or module with built-in circuit elements, increases exceeding those of the conventional modules with the result that the temperature of the heat generated by the mounted or embedded circuit elements becomes higher than those of the conventional modules. In such a case, the mounted or embedded circuit elements need to be cooled in order to make the circuit module or module with built-in circuit elements function normally, because active elements such as transistors and ICs are generally susceptible to heat. This requirement is particularly noticeable in the case of modules with built-in circuit elements in which the circuit elements are embedded deeply in the substrates.

In the module with built-in circuit elements shown in Fig. 14, although an attempt to increase the thermal conductivity of the electrically insulating materials is made by adding an inorganic filler to a thermosetting resin, there is a limit in the improvement of the thermal conductivity achieved only by addition of an inorganic filler, because the thermal conductivity of a thermosetting resin is generally very low. Therefore, if the power dealt by the module with built-in circuit elements increases, accompanied by an increase in the heat generation of the circuit elements as described earlier, there will arise such a problem that the heat generated from the circuit elements cannot be satisfactorily released outwardly from the module with built-in circuit elements. Although it is conceivable to increase the compounding ratio of the inorganic filler with the intension of further increasing the thermal conductivity of the electrically insulating materials composed of the inorganic filler and thermosetting resin, a higher compounding ratio of the inorganic filler deteriorates the flowability of the electrically insulating materials. In this case, since the embedding condition of the circuit elements when manufacturing the substrates of the module with built-in circuit elements becomes worse, there is a possibility that voids might be created around the circuit elements. To improve the embedding condition of the circuit elements thereby preventing the occurrence of voids, the pressure imposed during manufacture of the substrates may be increased. In this case, however, there is an increasing risk that the circuit elements will be damaged.

In the module with built-in circuit elements shown in Fig. 15, the thickness of the heat sink conductor needs to be increased in order to effectively release the heat which is generated by the circuit elements and the amount of which increases as the amount of power dealt by the module with built-in circuit elements increases. However, this causes an increase in the thickness of the module with built-in circuit elements itself, hindering miniaturization of it. In addition, where a thick heat sink conductor is embedded in the module with built-in circuit elements, there are problems that the process of manufacturing the thick heat sink conductor becomes specialized and that the embedding condition of the heat sink conductor relative to the electrically insulating materials deteriorates. Another problem is such that where a plurality of circuit elements are mounted on the same wiring, heat conduction from one of adjacent circuit elements to the other is enhanced by the presence of the thick heat sink conductor, so that the circuit element with a smaller heat value is heated by the heat generated from the circuit element with a greater heat value. Still another problem is such that since the process of manufacturing the module with built-in circuit elements shown in Fig. 15 includes a calcination step, circuit elements such as active elements (e.g., transistors and ICs) weak to heat and passive elements including organic compounds cannot be embedded in the electrically insulating materials. Additionally, since the wirings are formed from a high-resistance material such as tungsten and molybdenum, the electric power loss of the wirings is considerable.

### Disclosure of the Invention

The present invention is directed to overcoming the problems described above and a primary object of the invention is therefore to provide a module with built-in circuit elements which is easy to manufacture, has no disincentive to miniaturization, and uses electrically insulating resinous material capable of effectively outwardly releasing heat generated from circuit elements.

This object can be accomplished by a module with built-in circuit elements, wherein a plurality of substantially two-dimensionally formed wirings are stacked with an electrically insulating material interposed therebetween; said electrically insulating material is made of a mixture containing at least a filler and an electrically insulating resin; and one or more circuit elements are electrically connected to the wirings and at least part of the circuit elements is embedded in the electrically insulating material; and
wherein a heat sink member having higher thermal conductivity than that of the electrically insulating material is included, and the heat sink member and at least high heat generating circuit element among the circuit elements overlap each other when viewed in a laminating direction of the wirings, the high heat generating circuit element rising to higher temperature than other components of the module, while the module is in use.

With this arrangement, the heat generated from the high heat generating circuit element while the electronics device is in operation can be transferred to the electrically insulating material whose thermal conductivity is improved by addition of the filler and further transferred to the heat sink member having higher thermal conductivity than that of the electrically insulating material. As a result, a temperature rise in the high heat generating circuit element during the operation of the electronics device is restricted, so that the damage attributable to the high heat of the high heat generating circuit element can be prevented. That is, the above arrangement has the effect of operating the module with built-in circuit elements continuously and normally.

The heat sink member and the high heat generating circuit element are opposed to each other in the laminating direction of the wirings.

With this structure, the heat generated from the high heat generating circuit element while the electronics device is in operation can be transferred to the electrically insulating material whose thermal conductivity is improved by addition of the filler and further transferred effectively to the heat sink member having higher thermal conductivity than that of the electrically insulating material. As a result, a temperature rise in the high heat generating circuit element while the electronics device is in operation is restricted with high efficiency, so that damage attributable to the high heat of the high heat generating circuit element can be effectively prevented. That is, the above structure has the effect of operating the module with built-in circuit elements continuously and more normally.

The heat sink member may be disposed on a surface of the electrically insulating material.

With this structure, the heat generated from the high heat generating circuit element while the electronics device is in operation can be transferred to the electrically insulating material whose thermal conductivity is improved by addition of the filler and further transferred to the heat sink member having higher thermal conductivity than that of the electrically insulating material. Then, the heat can be released from the heat sink member to the outside of the module with built-in circuit elements. As a result, a temperature rise in the high heat generating circuit element while the electronics device is in operation is restricted with higher efficiency, so that damage attributable to the high heat of the high heat generating circuit element can be more effectively prevented. That is, the above structure has the effect of operating the module with built-in circuit elements continuously and more normally.

The area of the heat sink member is larger than that of the high heat generating circuit element when viewed in the laminating direction of the wirings.

With this structure, the heat generated from the high heat generating circuit element while the electronics device is in operation can be transferred to the electrically insulating material whose thermal conductivity is improved by addition of the filler and further transferred to the heat sink member having higher thermal conductivity than that of the electrically insulating material. Then, the heat can be released from the heat sink member to the outside of the module with built-in circuit elements. As a result, a temperature rise in the high heat generating circuit element while the electronics device is in operation is restricted with higher efficiency, so that damage attributable to the high heat of the high heat generating circuit element can be more effectively prevented. That is, the above structure has the effect of operating the module with built-in circuit elements continuously and more normally.

The high heat generating circuit element may be disposed on a surface of the electrically insulating material.

With this structure, the heat generated from the high heat generating circuit element while the electronics device is in operation can be transferred to the electrically insulating material whose thermal conductivity is improved by addition of the filler and further transferred effectively to the heat sink member having higher thermal conductivity than that of the electrically insulating material. The heat generated from the high heat generating circuit element can be directly released from the surface of the high heat generating circuit element to the outside of the module with built-in circuit elements. As a result, a temperature rise in the high heat generating circuit element while the electronics device is in operation is restricted with higher efficiency, so that damage attributable to the high heat of the high heat generating circuit element can be more effectively prevented. That is, the above structure has the effect of operating the module with built-in circuit elements continuously and more normally.

The heat sink member is electrically connected to the wirings.

With this structure, noise generated from, for example, the high heat generating circuit element while the electronics device is in operation and noise coming from the outside of the module with built-in circuit elements can be respectively shut out and electrically eliminated. This has the effect of increasing the reliability of the operation of the module with built-in circuit elements even when the electronics device is operated, for example, in a noisy environment.

An electrically conducting member for electrically connecting the plurality of wirings to one another is disposed close to the electrically insulating material, and there is a portion where the electrically conducting member and the heat sink member are heat-conductively connected.

With this structure, the heat can be directly transferred to the electrically conducting member without passing through the wirings, the heat having been generated from the high heat generating circuit element while the electronics device is in operation and transferred to the heat sink member which has higher thermal conductivity than that of the electrically insulating material by way of the electrically insulating material whose thermal conductivity is improved by addition of the filler. As a result, even if the electronics device operates over a long period of time, a temperature rise in the high heat generating circuit element can be continuously restricted with high efficiency. That is, this structure has the effect of not only preventing damage attributable to the high heat of the high heat generating circuit element in the long run, but also further increasing the long-term reliability of the operation of the module with built-in circuit elements.

The electrically conducting member may be a through hole.

The electrically conducting member may be an inner via hole.

This enables it to produce the electrically insulating material and the electrically conducting member with the conventionally used production facility and production process. As a result, it becomes unnecessary to construct a new facility and develop a new production process, so that the module with built-in circuit elements can be economically manufactured.

The heat sink member may take the form of a chip part.

This allows the heat sink member to be packaged by use of the commonly-used conventional chip part packaging system. As a result, it becomes unnecessary to construct a new facility and develop a new production process, so that the module with built-in circuit elements can be economically manufactured.

The heat sink member may contain a metal as a chief component.

With this, that is, provision of the heat sink member having very high thermal conductivity such as a metal or a material containing a metal as a chief component in the vicinity of the high heat generating circuit element, transient heat resistance can be reduced. This transient heat resistance is a kind of heat dissipating property and represents the degree of short-term heat dissipation subsequent to heat generation (i.e., the degree of the effect of heat dissipation upon instantaneous heat generation). If this transient heat resistance is small, heat spots are unlikely to be created so that the reliability (heat resistance) of the module with built-in circuit elements appears to increase when checked by a thermal cycle test.

The heat sink member may contain ceramics as a chief component.

This allows the heat sink member having high thermal conductivity to be made from a comparatively inexpensive material. In addition, the thermal conductivity of the heat sink member can be arbitrarily controlled by selecting a material. Additionally, since the heat sink member is a small piece, it can be arbitrarily disposed in the vicinity of any of the circuit elements that constitute the module with built-in circuit elements. As a result, it becomes possible to obtain a small module with built-in circuit elements which is capable of outwardly releasing the heat generated from the high heat generating circuit element according to the heat value, with a relatively inexpensive arrangement.

The thermal conductivity of the heat sink member is not less than three times that of the electrically insulating material.

This makes it possible to stably attain a heat resistance reducing effect. As a result, the high heat generating circuit element can be stably cooled.

The high heat generating circuit element and the heat sink member are disposed such that the area of a portion where they overlap each other when viewed in the laminating direction of the wirings is 40% or more of the area of the high heat generating circuit element when viewed in the laminating direction of the wirings.

This makes it possible to more stably attain a heat resistance reducing effect. In consequence, the high heat generating circuit element can be more stably cooled.

The distance between the high heat generating circuit element and the heat sink member exceeds 0 mm and is 0.5 mm or less.

This prevents the heat resistance between the high heat generating circuit element and the heat sink member from excessively increasing, so that the desirable effect of the invention can be easily achieved. In addition, since the thickness of the module with built-in circuit elements can be controlled, it can be formed into a suitable shape in view of miniaturization of the device. Specifically, such a design makes it possible to provide a module with built-in circuit elements which is short in height and has high heat dissipativity.

The high heat generating circuit element and the heat sink member are in close contact with each other through at least the electrically insulating material.

With this structure, the heat resistance between the high heat generating circuit element and the heat sink member lowers, compared to the case where there is a gap between them, so that the heat generated from the high heat generating circuit element can be stably released outward.

At least one of the wirings may be further located between the high heat generating circuit element and the heat sink member.

This has the effect of effectively releasing the heat generated from the high heat generating circuit element outward.

The heat sink member may be thicker than the wirings.

This increases not only the heat dissipativity of the heat sink member but also its heat capacity, so that a local temperature rise in the module with built-in circuit elements can be restrained.

The thickness of the heat sink member may be 0.1 mm or more and 1.0 mm or less.

This has the effect of effectively restraining a local temperature rise in the module with built-in circuit elements.

The module with built-in circuit elements according to the invention is formed such that the plurality of substantially two-dimensional wirings are stacked with the electrically insulating material held therebetween; the electrically insulating material is made from a mixture containing at least a filler and an electrically insulating resin; and one or more circuit elements are electrically connected to wirings and at least part of the circuit elements is embedded in the electrically insulating material,

The module being formed such that the circuit elements include a heat sink circuit element having higher thermal conductivity than the electrically insulating material and that the heat sink circuit element and a high heat generating circuit element overlap each other when viewed in the laminating direction of the wirings, the high heat generating circuit element being among the circuit elements and rising to higher temperature than other components of the module, while the module is in use.

With this structure, the heat, which is generated from the high heat generating circuit element while the electronics device is in operation can be transferred to the electrically insulating material whose thermal conductivity is improved by addition of the filler. This heat can be further transferred to the heat sink circuit element having higher thermal conductivity than the electrically insulating material. As a result, a temperature rise in the high heat generating circuit element during the operation of the electronics device can be restrained so that damage attributable to the high heat of the high heat generating circuit element can be prevented. That is, the above structure has the effect of making the module with built-in circuit elements operate normally and continuously. Additionally, since one of the circuit elements which constitute the module with built-in circuit elements can be utilized as the heat sink member having higher thermal conductivity than the electrically insulating material, there is no need to mount another member in addition to the circuit elements as described earlier. Further, since a space for packaging another member different from the circuit elements is unnecessary, the packaging density of the circuit elements of the module can be increased. This means that the module with built-in circuit elements can be further miniaturized.

The heat sink circuit element and the high heat generating circuit element are opposed to each other when viewed in the laminating direction of the wirings.

This makes it possible to transfer the heat, which is generated from the high heat generating circuit element while the electronics device is in operation, to the electrically insulating material whose thermal conductivity is improved by addition of the filler. This heat can be further transferred effectively to the heat sink circuit element having higher thermal conductivity than the electrically insulating material. As a result, a temperature rise in the high heat generating circuit element during the operation of the electronics device can be restrained with high efficiency so that damage attributable to the high heat of the high heat generating circuit element can be effectively prevented. That is, the above structure has the effect of making the module with built-in circuit elements operate more normally and continuously.

The heat sink circuit element may be disposed on a surface of the electrically insulating material.

This makes it possible to transfer the heat, which is generated from the high heat generating circuit element while the electronics device is in operation, to the electrically insulating material whose thermal conductivity is improved by addition of the filler. This heat can be further transferred to the heat sink circuit element having higher thermal conductivity than the electrically insulating material and then released from the heat sink circuit element to the outside of the module with built-in circuit elements. As a result, a temperature rise in the high heat generating circuit element during the operation of the electronics device can be restrained with higher efficiency so that damage attributable to the high heat of the high heat generating circuit element can be more effectively prevented. That is, the above structure has the effect of making the module with built-in circuit elements operate much more normally and continuously.

The area of the heat sink circuit element is larger than that of the high heat generating circuit element when viewed in the laminating direction of the wirings.

This makes it possible to transfer the heat, which is generated from the high heat generating circuit element while the electronics device is in operation, to the electrically insulating material whose thermal conductivity is improved by addition of the filler. This heat can be further transferred to the heat sink circuit element having higher thermal conductivity than the electrically insulating material and then released from the heat sink circuit element to the outside of the module with built-in circuit elements. As a result, a temperature rise in the high heat generating circuit element while the electronics device is in operation can be restrained with higher efficiency so that damage attributable to the high heat of the high heat generating circuit element can be more effectively prevented. That is, the above structure has the effect of making the module with built-in circuit elements operate much more normally and continuously.

The high heat generating circuit element may be disposed on a surface of the electrically insulating material.

This makes it possible to transfer the heat, which is generated from the high heat generating circuit element while the electronics device is in operation, to the electrically insulating material whose thermal conductivity is improved by addition of the filler. This heat can be further transferred effectively to the heat sink circuit element having higher thermal conductivity than the electrically insulating material. Additionally, the heat generated from the high heat generating circuit element can be released directly from the surface of the high heat generating circuit element to the outside of the module with built-in circuit elements. As a result, a temperature rise in the high heat generating circuit element during the operation of the electronics device can be restrained with higher efficiency so that damage attributable to the high heat of the high heat generating circuit element can be more effectively prevented. That is, the above structure has the effect of making the module with built-in circuit elements operate much more normally and continuously.

The heat sink circuit element may be a resistor.

The heat sink circuit element may be a capacitor.

The heat sink circuit element may be an inductor.

The heat sink circuit element may be a laminated body composed of a capacitor and an inductor.

With these structures, the circuit elements can satisfactorily function as the heat sink circuit element, since they are generally made from a material having high thermal conductivity. These circuit elements are those that constitute the module with built-in circuit elements so that the packaging density of the circuit elements of the module can be improved. This has the effect of providing a compact module with built-in circuit elements which continuously performs normal operation.

The laminated body may be disposed such that the capacitor is located in the vicinity of the high heat generating circuit element.

This satisfies such a requirement that a power semiconductor device, capacitor and inductor be desirably arranged so as to be close to one another in a converter circuit such as a switching power source, and enables it to release heat generated from the power semiconductor device outwardly from the module with built-in circuit elements. In addition, the heat generated from the power semiconductor device can be dissipated by the capacitor and at the same time, it is possible to obtain such a shielding effect that a leakage flux generated by the inductor can be shut off by the metal layer of the capacitor. As a result, a compact converter module capable of performing stable operation can be constructed by the module with built-in circuit elements.

The capacitor may be a ceramic capacitor.

The capacitor may be a solid electrolytic capacitor.

With these structures, the circuit elements can satisfactorily function as the heat sink circuit element, as they are generally made from a material having high thermal conductivity.

The inductor may have a laminated structure composed of windings and a magnetic substance and takes the form of a thin sheet.

The inductor may have a laminated structure composed of windings and a magnetic substance and the windings may be sheet-like coils formed by plating.

The inductor may have a laminated structure composed of windings and a magnetic substance and the magnetic substance may comprise at least a thin metallic body.

With these structures, the circuit elements can satisfactorily function as the heat sink circuit element, since they are generally made from a material having high thermal conductivity.

The thermal conductivity of the heat sink circuit element is not less than three times that of the electrically insulating material.

This makes it possible to stably attain a heat resistance reducing effect. As a result, the high heat generating circuit element can be stably cooled.

The high heat generating circuit element and the heat sink circuit element overlap each other such that the overlapping area when viewed in the laminating direction of the wirings is 40% or more of the area of the high heat generating circuit element when viewed in the laminating direction of the wirings.

This makes it possible to more stably attain a heat resistance reducing effect. As a result, the high heat generating circuit element can be more stably cooled.

The distance between the high heat generating circuit element and the heat sink circuit element may exceed 0 mm and may be 0.5 mm or less.

This prevents the heat resistance between the high heat generating circuit element and the heat sink circuit element from excessively increasing so that the desirable effect of the invention can be more easily exerted. In addition, since the thickness of the module with built-in circuit elements is restricted, it can be formed into a suitable shape in view of miniaturization of the device. More specifically, such a design makes it possible to provide a module with built-in circuit elements which is low in height and has high heat dissipativity.

The high heat generating circuit element may be in close contact with the heat sink circuit element through at least the electrically insulating material.

With this structure, the heat resistance between the high heat generating circuit element and the heat sink circuit element lowers, compared to the case where there is a gap between them, so that the heat generated from the high heat generating circuit element can be stably released outward.

At least one of the wirings may be further located between the high heat generating circuit element and the heat sink circuit element.

This makes it possible to effectively dissipate the heat generated from the high heat generating circuit element outward.

In addition, the heat sink circuit element may be thicker than the wirings.

This increases not only the heat dissipativity of the heat sink circuit element but also its heat capacity, so that a local temperature rise in the module with built-in circuit elements can be restrained.

The thickness of the heat sink circuit element may be 0.1 mm or more and 1.0 mm or less.

This makes it possible to effectively restrain a local temperature rise in the module with built-in circuit elements.

These objects as well as other objects, features and advantages of the invention will become apparent to those skilled in the art from the following description with reference to the accompanying drawings.

### Brief Explanation of the Drawings

Fig. 1 is a sectional view diagrammatically showing the structure of a module with built-in circuit elements according to a first embodiment of the invention.
Fig. 2 is a sectional view diagrammatically showing the structure of a module with built-in circuit elements according to a second embodiment of the invention.
Fig. 3 is a sectional view diagrammatically showing the structure of a module with built-in circuit elements according to a third embodiment of the invention.
Fig. 4 is a sectional view diagrammatically showing the structure of a module with built-in circuit elements according to a fourth embodiment of the invention.
Fig. 5 is a sectional view diagrammatically showing the structure of a module with built-in circuit elements according to a fifth embodiment of the invention.
Fig. 6 is a sectional view diagrammatically showing the structure of a module with built-in circuit elements according to a sixth embodiment of the invention.
Fig. 7 is a sectional view diagrammatically showing the structure of a module with built-in circuit elements according to a seventh embodiment of the invention.
Fig. 8 is a sectional view diagrammatically showing part of a switching power source modules according to an eighth embodiment of the invention.
Fig. 9 is a sectional view diagrammatically showing part of a switching power source module having another configuration according to the eighth embodiment of the invention.
Fig. 10 is a typical switching power source module circuit diagram.
Fig. 11 is a sectional view diagrammatically showing a module with built-in circuit elements according to a ninth embodiment of the invention.
Fig. 12 is a diagram showing, according to the ninth embodiment of the invention, the relationship between the ratio of the area of a portion where a circuit element and a heat sink member are opposed to each other to the area of a principal surface of the circuit element and the heat resistance ratio when heat is transmitted from the circuit element to the heat sink member.
Fig. 13 is a diagram showing, according to the ninth embodiment of the invention, the relationship between the ratio of the thermal conductivity of an electrically insulating material to the thermal conductivity of the heat sink member and the heat resistance ratio when heat is transmitted from the circuit element to the heat sink member, in a case where the heat sink member of high thermal conductivity and the circuit element, which have the same area, are opposed to each other.
Fig. 14 is a perspective sectional view showing part of one example of conventional modules with built-in circuit elements configured to outwardly dissipate heat generated from an embedded circuit element.
Fig. 15 is a perspective view showing part of one example of conventional modules with built-in circuit elements configured to outwardly dissipate heat generated from a mounted circuit element.

### Best Mode for Carrying out the Invention

Referring now to the accompanying drawings, embodiments of the invention will be described.

### (First Embodiment)

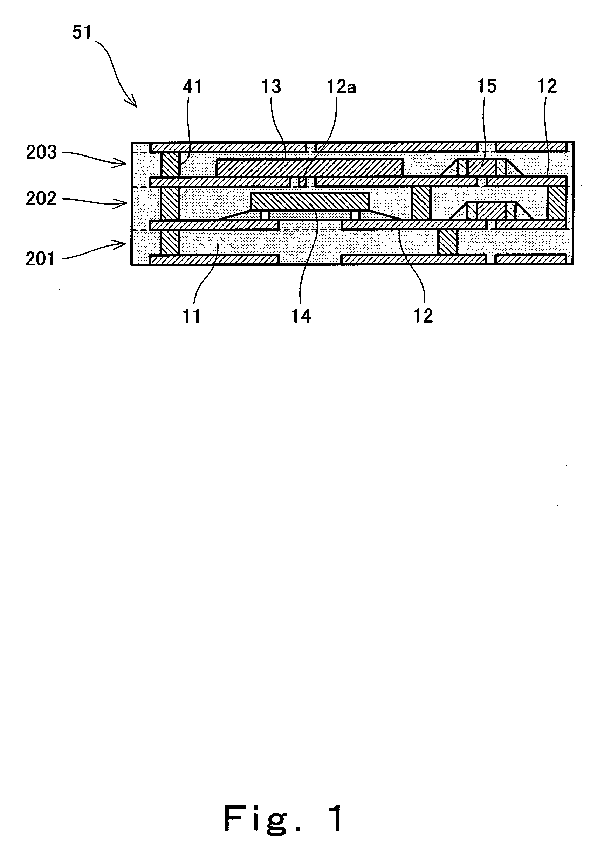

Reference is made to Fig. 1 to describe a first embodiment of the invention.

The first embodiment of the invention is associated with a first example of cases where other members than circuit elements are used as a heat sink member having high thermal conductivity, the members being made from a metal, ceramics or the like.

Fig. 1 is a sectional view diagrammatically showing the structure of a module with built-in circuit elements according to the first embodiment of the invention.

The module with built-in circuit elements 51 shown in Fig. 1 has (a) an electrically insulating material 11; (b) a plurality of wirings (wiring patterns) 12 and signal patterns 12a which are adhered to the electrically insulating material 11; (c) an inner via hole 41 which electrically interconnects the plurality of wirings 12 so as to have a specified connecting relationship; (d) circuit elements 14, 15 which are embedded so as to be electrically connected to the wirings 12 and heat-conductively connected to the electrically insulating material 11; and (e) a heat sink member 13 having higher thermal conductivity than the electrically insulating material 11 and disposed in substantially parallel with and opposed to a principal surface of the circuit element 14. The module with built-in circuit elements 51 shown in Fig. 1 is formed by stacking substrates (layers) 201, 202, 203.

The electrically insulating material 11 is made of a mixture of an inorganic filler and an electrically insulating resin. Examples of the inorganic filler include: aluminum oxide; magnesium oxide; boron nitride; aluminum nitride; silicon dioxide; silicon carbide; and ferrite. As the electrically insulating resin, thermosetting resin such as epoxy resin, phenol resin, cyanate resin, fluorocarbon resin, polyester, polyphenylene ether, or polyimide may be used. In the electrically insulating material 11, the compounding ratio between the inorganic filler and the electrically insulating resin is determined such that the properties of the electrically insulating material 11 such as linear expansion coefficient, thermal conductivity, relative permittivity and magnetic permeability have appropriate values. In cases where the circuit element 14 is a high heat generating circuit element for instance, the electrically insulating material 11 in the vicinity of the circuit element 14 is thermally expanded by heat generated from the circuit element 14 while the device is in operation. However, the thermal expansion amount of the electrically insulating material 11 in the vicinity of the circuit element 14 can be reduced if the linear expansion coefficient of the electrically insulating material 11 is made close to the linear expansion coefficient of the circuit element 14 by the above-described means. In this case, the internal stress of the electrically insulating material 11 due to temperature changes in the circuit element 14 can be reduced, which increases the reliability of the operation of the module with built-in circuit elements 51.

The wirings 12 and the signal patterns 12a are made of a substance having electrical conductivity and more specifically formed by molding beaten copper, an electrically-conductive resin composition or like into a specified shape. Since the area of the wirings can be thus reduced by use of a substance having high electrical conductivity, miniaturization of the module with built-in circuit elements 51 can be promoted. At least one of the wirings 12 and one of the signal patterns 12a are located between the circuit element 14 and the heat sink member 13.

The circuit element 14 is an active element such as a power transistor and a power IC (e.g., a three-terminal regulator) and has relatively high heat generation temperature and a high heat value. On the other hand, the circuit element 15 is a passive element such as a ceramic capacitor, solid electrolytic capacitor and inductor and has relatively low heat generation temperature and a small heat value. The circuit elements 14, 15 are mounted on a specified position of their associated wirings 12 by arbitrary packaging means such as soldering. The principal and side surfaces of the circuit elements 14, 15 are in contact with the electrically insulating material 11. That is, they are heat-conductively connected to the electrically insulating material 11.

It is desirable to use a metal or ceramics as the material of the heat sink member 13 having high thermal conductivity. The reason for this is that since the thermal conductivity of metals and ceramics is about one or two figures higher than the thermal conductivity of the electrically insulating material 11 composed of an inorganic filler and a thermosetting resin, the heat generated from the circuit element 14 can be effectively dissipated outward. As the metal, copper (thermal conductivity = 398 (W/m · K)), aluminum (thermal conductivity = 237 (W/m · K)) or the like can be suitably used. As the ceramics, aluminum oxide (thermal conductivity = 22 (W/m · K)), aluminum nitride (thermal conductivity = 170 (W/m · K)) or the like can be suitably used.

Where the heat sink member 13 having high thermal conductivity is made from a metal, noise generated from the circuit element 14 etc. and noise coming from outside can be shut off, because a metal has the effect of shutting off electromagnetic noise. Where the heat sink member 13 having high thermal conductivity is made from ceramics, the same effect can be attained by forming a metal film on the surface of the ceramics (at least the face opposite to the mounting surface of the ceramics).

The heat sink member 13 having high thermal conductivity is preferably in the form of a chip part. The reason for this is that if the heat sink member 13 is in chip form, it can be packaged by use of the commonly-used conventional chip part packaging equipment. In addition, it is desirable that the thickness of the heat sink member 13 be equal to or less than the thickness of the circuit element 15 disposed on the same wiring layer. The reason for this is that by making the thickness of the heat sink member 13 equal to or less than the thickness of the circuit element 15, the thickness of the module with built-in circuit element is not affected so that the module with built-in circuit element can be miniaturized.

If the heat sink member 13 having high thermal conductivity needs to be electrically insulated from the wirings 12, an insulating film may be applied to the surface of the heat sink member 13. If the heat sink member 13 is made from ceramics, there is no need to apply an insulating film because ceramics itself is an insulator.

Further, the heat sink member 13 having high thermal conductivity is preferably thicker than the wirings 12 and the signal patterns 12a. In this case, the thickness of the heat sink member 13 is preferably 0.1 mm or more and 1.0 mm or less. Thereby, the heat generated from the circuit element 14 can be effectively dissipated.

The distance between the heat sink member 13 and the circuit element 14 is preferably more than 0 mm and no more than 0.5 mm. Thereby, the heat generated from the circuit element 14 can be more effectively dissipated.

The inner via hole 41 electrically interconnects the plurality of wirings 12 formed in the module with built-in circuit elements 51 such that a specified circuit is formed. The inside of the inner via hole 41 is filled with a conductive resin which is electrically connected to the surfaces of the wirings 12, so that opposed pairs of wirings 12 are respectively electrically interconnected. The inner via hole 41 electrically connects the plurality of wirings 12 in the module with built-in circuit elements so as to form a specified circuit and, at the same time, heat-conductively interconnects the wirings 12. Apart from the inner via hole such as described above, a through hole may be used for electrically interconnecting the wirings. However, the inner via hole is more suitable in view of high-density packaging of circuit elements.

As shown in Fig. 1, in the module with built-in circuit elements 51, the heat sink member 13 having higher thermal conductivity than the electrically insulating material 11 is disposed in substantially parallel with and opposed to the principal surface of the circuit element 14. Therefore, the heat generated from the circuit element 14 is transmitted to the electrically insulating material 11 laid over the circuit element 14 and further to the heat sink member 13 having high thermal conductivity by way of the wirings 12. Then, the heat passes through the electrically insulating material 11 and the wirings 12 again, so that it is dissipated outwardly from the module with built-in circuit elements 51. As a result, a temperature rise in the circuit element 14 during operation of the device is restrained so that damage to the circuit element 14 can be prevented and the module with built-in circuit elements 51 operates normally and continuously. Additionally, since the provision of the heat sink member 13 having high thermal conductivity leads to improved heat dissipativity, the weight percentage of the inorganic filler of the electrically insulating material 11 can be reduced. This contributes to an improvement in the property of embedding of the circuit element 14 etc. when fabricating the module with built-in circuit elements 51. In addition, since the external stress imposed on the circuit element 14 etc. can be reduced, damage to the circuit element can be prevented.

### (Second Embodiment)

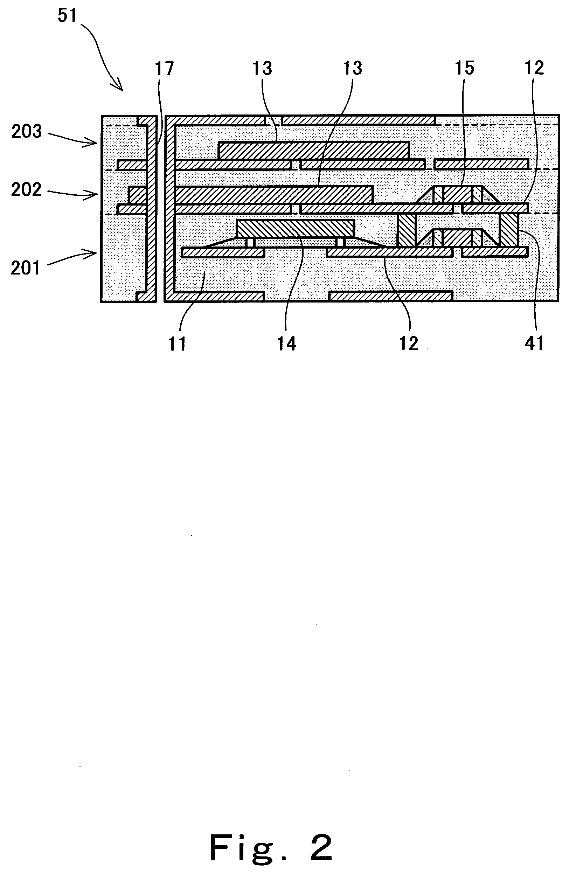

A second embodiment of the invention will be described with reference to Fig. 2.

The second embodiment of the invention is associated with a second example of cases where other members than circuit elements are used as a heat sink member having high thermal conductivity, the members being made from a metal, ceramics or the like.

Fig. 2 is a sectional view diagrammatically showing the structure of a module with built-in circuit elements according to the second embodiment of the invention.

The module with built-in circuit elements 51 shown in Fig. 2 has (a) the electrically insulating material 11; (b) the plurality of wirings 12 adhered to the electrically insulating material 11; (c) a plurality of inner via holes 41 which electrically interconnect the plurality of wirings 12 so as to have a specified connecting relationship; (d) the circuit elements 14, 15 which are embedded so as to be electrically connected to the wirings 12 and heat-conductively connected to the electrically insulating material 11; (e) a plurality of heat sink members 13 having higher thermal conductivity than the electrically insulating material 11 and disposed in substantially parallel with and opposed to the principal surface of the circuit element 14; and (f) a through hole 17.

Herein, the module with built-in circuit elements 51 has two heat sink members 13 having high thermal conductivity as shown in Fig. 2. These heat sink members 13 are substantially parallel to each other. They are disposed in substantially parallel with and opposed to the principal surface of the circuit element 14. Further, one of the plurality of heat sink members 13 is heat-conductively, directly connected to the through hole 17. Even if the circuit element 14 is embedded deep in the module with built-in circuit elements 51 as shown in Fig. 2, the heat generated by the circuit element 14 is transferred to the heat sink members 13 having high thermal conductivity through the electrically insulating member 11 and the wirings 12 and then to a principal surface of the module with built-in circuit elements 51 by way of the through hole 17. The heat which has reached the principal surface of the module with built-in circuit elements 51 is dissipated from the principal surface to the outside of the module with built-in circuit elements 51. As a result, the same effect as of the first embodiment of the invention can be achieved by the second embodiment. Except the above point, the second embodiment does not differ from the first embodiment.

### (Third Embodiment)

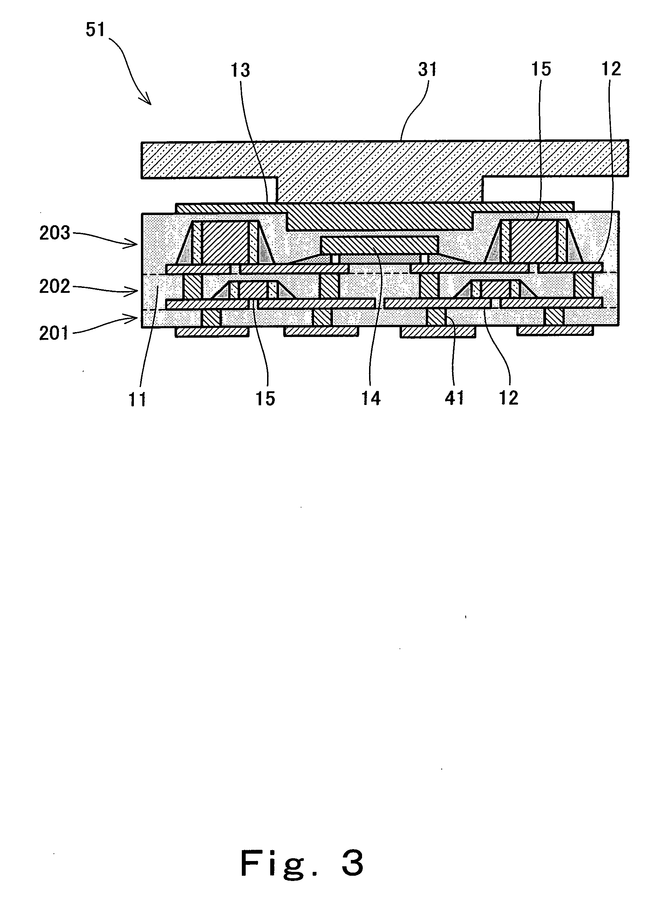

A third embodiment of the invention will be described with reference to Fig. 3.

The third embodiment of the invention is associated with a third example of cases where other members than circuit elements are used as a heat sink member having high thermal conductivity, the members being made from a metal, ceramics or the like.

Fig. 3 is a sectional view diagrammatically showing the structure of a module with built-in circuit elements according to the third embodiment of the invention.

The module with built-in circuit elements 51 shown in Fig. 3 has (a) the electrically insulating material 11; (b) the plurality of wirings 12 adhered to the electrically insulating material 11; (c) the plurality of inner via holes 41 which electrically interconnect the plurality of wirings 12 so as to have a specified connecting relationship; (d) the circuit elements 14, 15 which are embedded so as to be electrically connected to the wirings 12 and heat-conductively connected to the electrically insulating material 11; (e) the heat sink member 13 having higher thermal conductivity than the electrically insulating material 11 and disposed in substantially parallel with and opposed to the principal surface of the circuit element 14; and (f) a casing 31 heat-conductively connected to the heat sink member 13.

As shown in Fig. 3, in the module with built-in circuit elements 51, the heat sink member 13 having high thermal conductivity is disposed in substantially parallel with and opposed to the circuit element 14, exposing itself from the surface of the module with built-in circuit elements 51. The casing 31, which is a forcibly cooling means for outwardly releasing heat, is in contact or close contact with the top of the heat sink member 13 having high thermal conductivity in a heat-conductive manner. The heat generated from the circuit element 14 is transferred to the heat sink member 13 having high thermal conductivity through the electrically insulating material 11 and then released outwardly from the module with built-in circuit elements 51 through the casing 31. As a result, the same effect as of the first embodiment of the invention can be achieved by the third embodiment. Except the above point, the third embodiment does not differ from the first embodiment.

### (Fourth Embodiment)

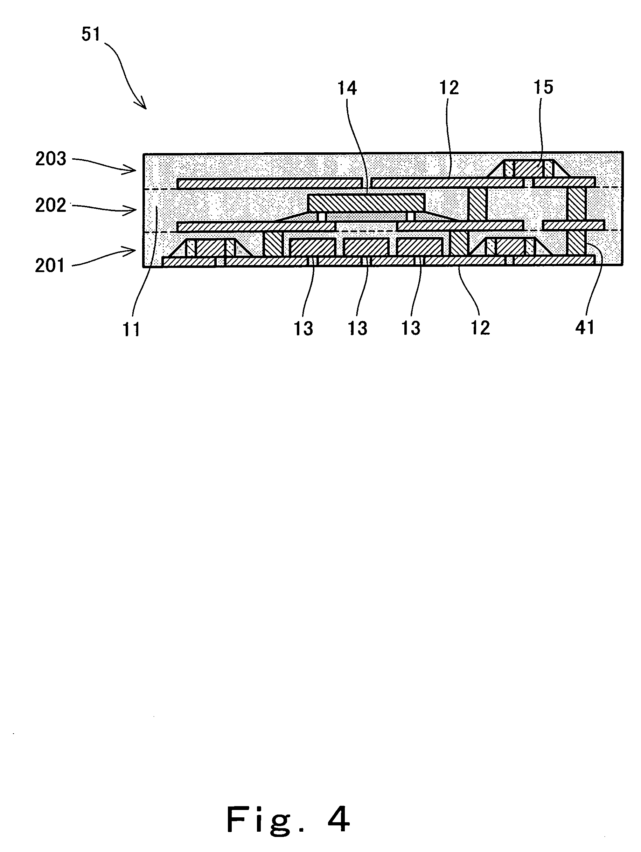

A fourth embodiment of the invention will be described with reference to Fig. 4.

The fourth embodiment of the invention is associated with a fourth example of cases where other members than circuit elements are used as a heat sink member having high thermal conductivity, the members being made from a metal, ceramics or the like.

Fig. 4 is a sectional view diagrammatically showing the structure of a module with built-in circuit elements according to the fourth embodiment of the invention.

The module with built-in circuit elements 51 shown in Fig. 4 has (a) the electrically insulating material 11; (b) the plurality of wirings 12 adhered to the electrically insulating material 11; (c) the plurality of inner via holes 41 which electrically interconnect the plurality of wirings 12 so as to have a specified connecting relationship; (d) the circuit elements 14, 15 which are embedded so as to be electrically connected to the wirings 12 and heat-conductively connected to the electrically insulating material 11; and (e) a plurality of heat sink members 13 having higher thermal conductivity than the electrically insulating material 11 and disposed in substantially parallel with and opposed to the principal surface of the circuit element 14.

As shown in Fig. 4, in the module with built-in circuit elements 51, there are provided a plurality of heat sink members 13 having high thermal conductivity on the wirings 12 which constitutes one principal surface of the module with built-in circuit elements 51. Therefore, the heat generated from the circuit element 14 is transferred to the heat sink members 13 having high thermal conductivity through the electrically insulating material 11 and released outwardly from the module with built-in circuit elements 51 through the wirings 12. As a result, the same effect as of the first embodiment of the invention can be achieved by the fourth embodiment. Except the above point, the fourth embodiment does not differ from the first embodiment.

### (Fifth Embodiment)

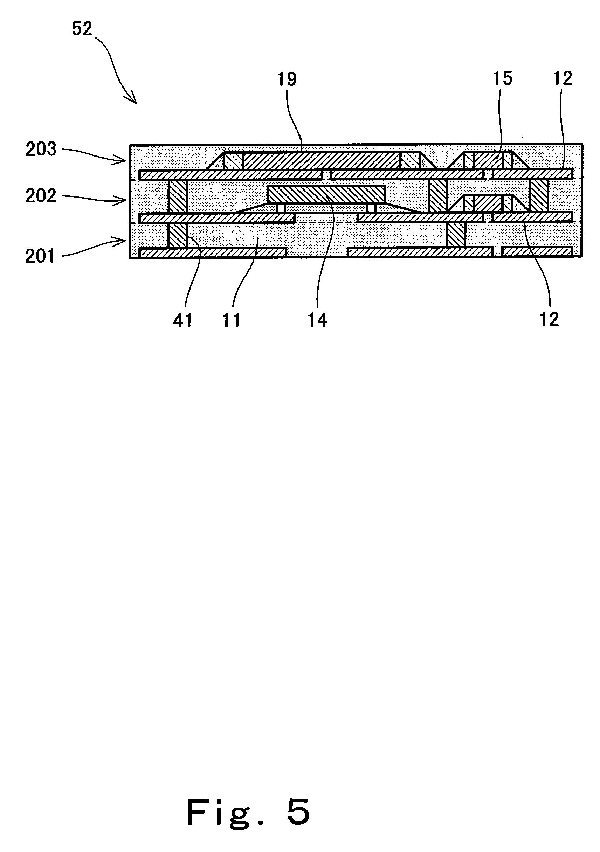

A fifth embodiment of the invention will be described with reference to Fig. 5.

The fifth embodiment of the invention is associated with a first example of cases where a circuit element is used as the heat sink member having high thermal conductivity.

Fig. 5 is a sectional view diagrammatically showing the structure of a module with built-in circuit elements according to the fifth embodiment of the invention.

The module with built-in circuit elements 52 shown in Fig. 5 has (a) the electrically insulating material 11; (b) the plurality of wirings 12 adhered to the electrically insulating material 11; (c) the plurality of inner via holes 41 which electrically interconnect the plurality of wirings 12 so as to have a specified connecting relationship; (d) the circuit elements 14, 15 which are embedded so as to be electrically connected to the wirings 12 and heat-conductively connected to the electrically insulating material 11; and (e) a circuit element 19 which has higher thermal conductivity than the electrically insulating material 11 and is disposed in substantially parallel with and opposed to the principal surface of the circuit element 14.

As shown in Fig. 5, the module with built-in circuit elements 52 uses, as the heat sink member having high thermal conductivity, the circuit element 19 which is a component of the circuit. The circuit element 19 is disposed at a specified position on the wirings 12 so as to be substantially parallel to and opposed to the principal surface of the circuit element 14. The heat generated from the circuit element 14 is transferred to the circuit element 19 by way of the electrically insulating material 11 and the wirings 12 and then released outwardly from the module with built-in circuit elements 52 through the electrically insulating material 11. As a result, the same effect as of the first embodiment of the invention can be achieved by the fifth embodiment. Except the above point, the fifth embodiment does not differ from the first embodiment.

The circuit element 19 having high thermal conductivity is a circuit element which functionally operates in the electronic circuit of the module with built-in circuit elements. As the circuit element 19, various kinds of circuit elements may be used examples of which include capacitors, inductors, resistors and semiconductor devices. Where a semiconductor device capable of dealing with a large amount of power is used as the circuit element 14, it is necessary to mount a smoothing capacitor in a power source line (not shown) of the module with built-in circuit elements 52. In a power conversion circuit such as converters, an inductor needs to be disposed in the vicinity of the semiconductor device. In such a case, the heat generated by the circuit element 14 which deals with a large amount of power is released outwardly from the module with built-in circuit elements 52 thanks to the effect of the capacitor, inductor etc. arranged in the neighborhood of the circuit element 14 as described earlier. Unlike the first embodiment, the present embodiment does not use a new member exclusively used for cooling the circuit element 14, and therefore, the packaging density of the circuit elements can be increased. In addition, the circuit element 19 having high thermal conductivity is placed in the vicinity of the circuit element 14, so that the wiring which electrically interconnect them can be minimized. This has a beneficial effect on the reduction of noise generated by the circuit. Further, since the inductor etc. for the wiring itself can be minimized, an improvement in the performance of the module with built-in circuit elements can be expected.

By use of a laminated ceramic capacitor as the circuit element 19 for heat dissipation, it becomes possible to effectively outwardly dissipate the heat generated by the circuit element 14. The reason for this is that although a typical laminated ceramic capacitor uses barium titanate having low thermal conductivity as a dielectric material, it includes a metallic internal electrode formed therein, the electrode being made of nickel, copper, silver or the like and accounting for about one half of the volume of the laminated ceramic capacitor. Thanks to this metallic internal electrode in the form of laminate, the laminated ceramic capacitors can provide good thermal conductivity which is as high as that of metals particularly in a lateral direction. As a result, the heat generated by the circuit element 14 can be effectively dissipated.

### (Sixth Embodiment)

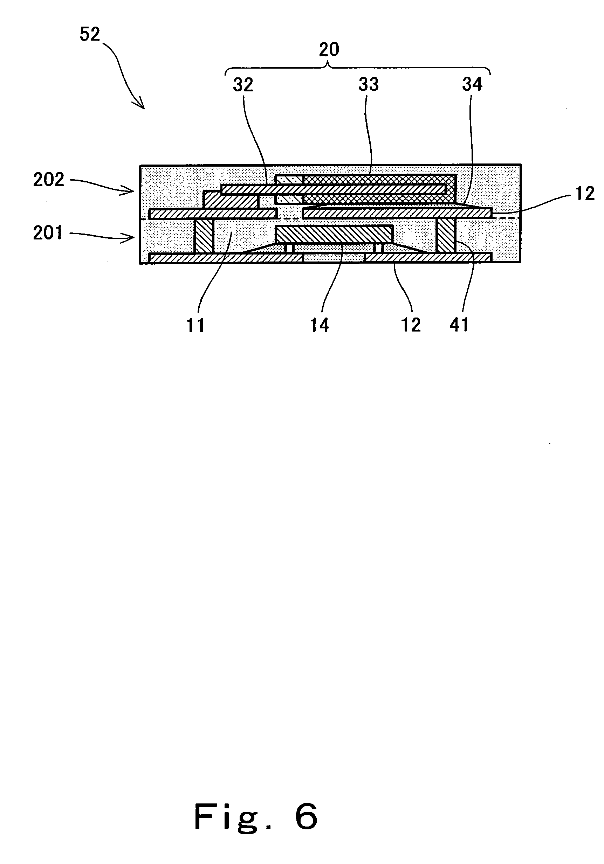

Reference is made to Fig. 6 to describe a sixth embodiment of the invention.

The sixth embodiment of the invention is associated with a second example of cases where a circuit element is used as the heat sink member having high thermal conductivity.

Fig. 6 is a sectional view diagrammatically showing the structure of a module with built-in circuit elements according to the sixth embodiment of the invention.

The sixth embodiment will be discussed in the context of a case where a solid electrolytic capacitor is used as the heat sink member having high thermal conductivity. In a typical solid electrolytic capacitor, an anodic oxide film is formed on the surface of a valve sheet metal which is etched in order to create more surface area and the composite of the valve sheet metal and the anodic oxide film is utilized as a dielectric material. The solid electrolytic capacitor is produced in such a way that solid electrolyte, a carbon layer and a silver conductive resin layer are formed in other areas than the anode leader of the dielectric material (the capacitor formed in this stage is called "a capacitor element assembly") and after an anode terminal is connected to a cathode terminal, packaging is done by transfer molding, potting or the like. However, the solid electrolytic capacitor packaged by transfer molding, potting or the like is not suited for use in a module with built-in circuit elements, because it is difficult to miniaturize and has low thermal conductivity. To solve this problem, the module with built-in circuit elements of the present embodiment is configured such that the capacitor element assembly is directly laid over the wirings without connecting the anode and cathode terminals thereto.

The module with built-in circuit elements 52 shown in Fig. 6 has (a) the electrically insulating material 11; (b) the plurality of wirings 12 adhered to the electrically insulating material 11; (c) the plurality of inner via holes 41 which electrically interconnect the plurality of wirings 12 so as to have a specified connecting relationship; (d) the circuit element 14 which is embedded so as to be electrically connected to the wirings 12 and heat-conductively connected to the electrically insulating material 11; (e) a valve sheet metal 32 disposed in substantially parallel with and opposed to the principal surface of the circuit element 14; (f) a carbon layer 33 formed around the valve sheet metal 32; and (g) a silver conductive resin layer 34 for electrically connecting the carbon layer 33 and the wirings 12. The capacitor element assembly functioning as a solid electrolytic capacitor is composed of the valve sheet metal 32, the carbon layer 33, the silver conductive resin layer 34, an anodic oxide film (not shown) and a solid electrolyte (not shown). Herein, the capacitor element assembly having such configuration is used as a circuit element 20.

As shown in Fig. 6, the module with built-in circuit elements 52 uses, as the heat sink member having high thermal conductivity, the circuit element 20 which is a component of the circuit. The circuit element 20 is disposed at a specified position on the wirings 12 so as to be substantially parallel to and opposed to the principal surface of the circuit element 14. Therefore, the heat generated from the circuit element 14 is transferred to the circuit element 20 by way of the electrically insulating material 11 and the wirings 12 and then released outwardly from the module with built-in circuit elements 52 through the electrically insulating material 11. As a result, the same effect as of the first embodiment of the invention can be achieved by the sixth embodiment. Except the above point, the sixth embodiment does not differ from the first embodiment.

As the solid electrolytic capacitor, an aluminum solid electrolytic capacitor may be suitably used. The reason for this is that an aluminum plate is used as the valve sheet metal 32 in this aluminum solid electrolytic capacitor and this aluminum plate accounts for about one half of the volume of the capacitor element assembly, which contributes to an improvement in the thermal conductivity of the device.

In addition, since the capacitor element assembly of this embodiment is built in the electrically insulating material 11, packaging by transfer molding, potting or the like is unnecessary.

### (Seventh Embodiment)

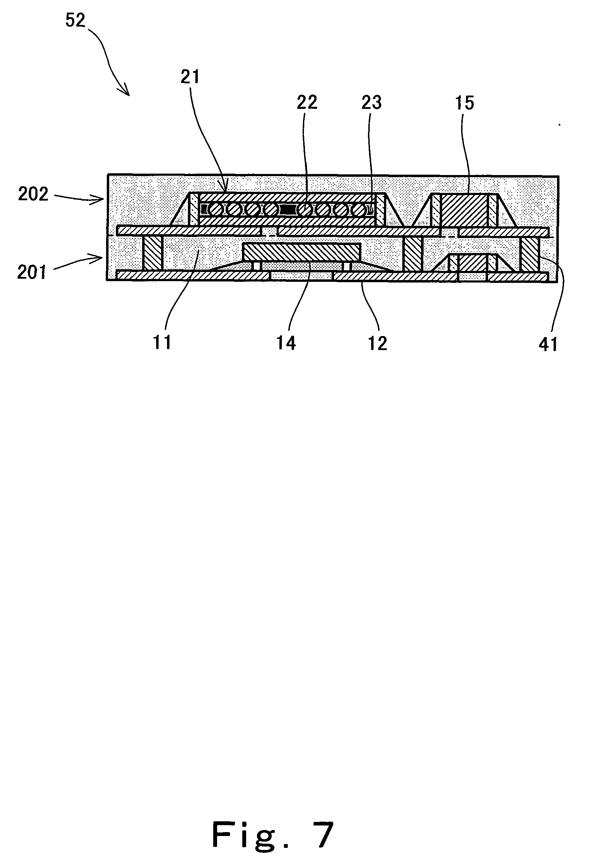

Reference is made to Fig. 7 to describe a seventh embodiment of the invention.

The seventh embodiment of the invention is associated with a third example of cases where a circuit element is used as the heat sink member having high thermal conductivity.

Fig. 7 is a sectional view diagrammatically showing the structure of a module with built-in circuit elements according to the seventh embodiment of the invention.

The module with built-in circuit elements 52 shown in Fig. 7 has (a) the electrically insulating material 11; (b) the plurality of wirings 12 adhered to the electrically insulating material 11; (c) the plurality of inner via holes 41 which electrically interconnect the plurality of wirings 12 so as to have a specified connecting relationship; (d) the circuit elements 14, 15 which are embedded so as to be electrically connected to the wirings 12 and heat-conductively connected to the electrically insulating material 11; and (e) a circuit element 21 having higher thermal conductivity than the electrically insulating material 11 and disposed in substantially parallel with and opposed to the principal surface of the circuit element 14. The circuit element 21 is an inductor and composed of wound sheet-like conductors 22 and a magnetic layer 23.

As shown in Fig. 7, the module with built-in circuit elements 52 uses, as the heat sink member having high thermal conductivity, the circuit element 21 which is a component of the circuit. The circuit element 21 is disposed at a specified position on the wirings 12 so as to be substantially parallel to and opposed to the principal surface of the circuit element 14. Therefore, the heat generated from the circuit element 14 is transferred to the circuit element 21 by way of the electrically insulating material 11 and the wirings 12 and then released outwardly from the module with built-in circuit elements 52 through the electrically insulating material 11. As a result, the same effect as of the first embodiment of the invention can be achieved by the seventh embodiment. Except the above point, the seventh embodiment does not differ from the first embodiment.

In typical inductors, a wound conductor made from a metal and a magnetic layer made from a sintered magnetic substance or metal are used. Since the metal and sintered magnetic substance used for these members have high thermal conductivity, the inductor has high thermal conductivity and is therefore suited for use in a module with built-in circuit elements. However, the typical inductors are difficult to thin because they are designed to have a sintered magnetic substance around which a conducting wire is wound. Further, the sintered magnetic substance is liable to damage caused by pressurization during molding. Since a winding formed by a conductive wire has a void part within it, it is not suited for use as an embedded circuit element. Taking these drawbacks into account, the seventh embodiment is designed such that the inductor 21 is formed by arranging the wound sheet-like conductors 22 and the magnetic layer 23 in a flat manner as shown in Fig. 7. Thanks to the shape of the flat inductor 21 thus formed, the flat inductor 21 is able to withstand molding pressure imposed on it while the device is embedded. These wound conductors 22 have good planarity and are therefore preferably used in the form of a sheet-like coil. For producing a sheet-like coil, etching and plating may be employed. If etching is employed, a line distance more than the thickness of the conductor is created between the windings of the coil and it is, therefore, difficult to increase the ratio of the sectional area of the conductor to the total sectional area of the winding parts (i.e., lamination factor). The lamination factor obtained by etching is usually 50% or less. For this reason, plating is more preferable for manufacture of the sheet-like coil. In the case of plating, even if the thickness of the conductor is 80 µ m or more, a line distance of 20 µm or less can be attained. That is, the lamination factor can be improved. An improvement in the lamination factor leads to a reduction in the resistance component of the inductor so that power loss due to the inductor can be lessened. Moreover, the volume of the conductor can be increased, resulting in a further improvement in the thermal conductivity of the inductor. In the case of an inductor formed by etching or plating, the space between the conductors is filled with resin. This eliminates the void part inside the windings, while enhancing electric insulation between the conductors. It is also possible to form an inductor by making holes in the center or periphery of the sheet-like windings and filling the holes with a magnetic substance. In this case, the material of the magnetic substance used for filling the holes may be prepared by blending resin with a sintered magnetic powder or metal magnetic powder. With such a technique, the thermal conductivity of the inductor 21 in a thickness-wise direction can be increased while improving the inductance value of the inductor 21.

Examples of the material of the magnetic layer 23 include sintered magnetic substances, mixtures of magnetic powder and resin, and metal magnetic foils. Among them, magnetic powder/resin mixtures and metal magnetic foils have high strength so that the strength of the device increases if they are used for an inductor. Therefore, they are suitably used for an embedded circuit element. Metal magnetic foils have high magnetic permeability and a noise shut-off effect so that if they are disposed in the neighborhood of an object susceptible to noise (e.g., a semiconductor device), the influence of noise can be reduced. Although the wound conductors 22 described herein is single-layered, it may be multiple-layered. By use of multiple-layered wound conductors 22, the arrangement of the terminals of the windings can be facilitated.

### (Eighth Embodiment)

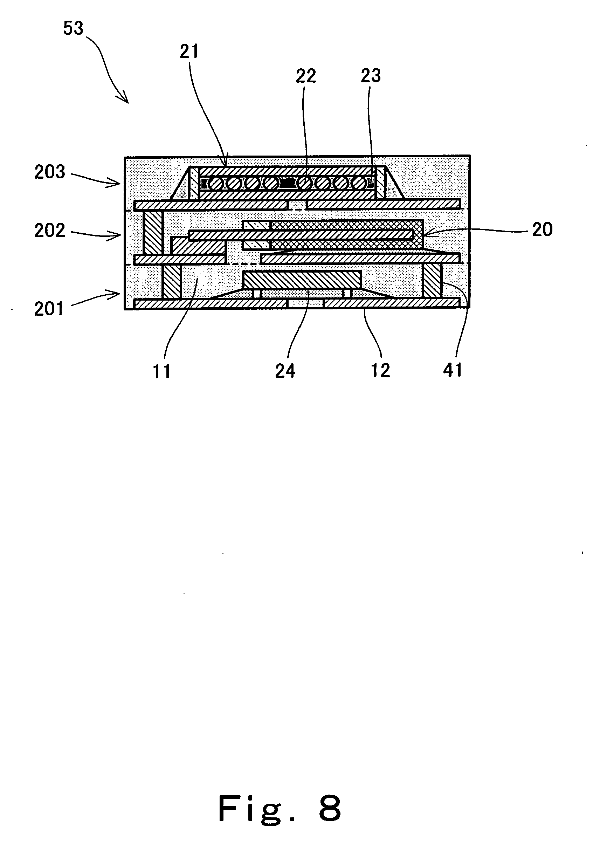

Reference is made to Figs. 8 to 10 to describe an eighth embodiment of the invention.

In the eighth embodiment of the invention, a switching power source module will be described as an example of the module with built-in circuit elements.

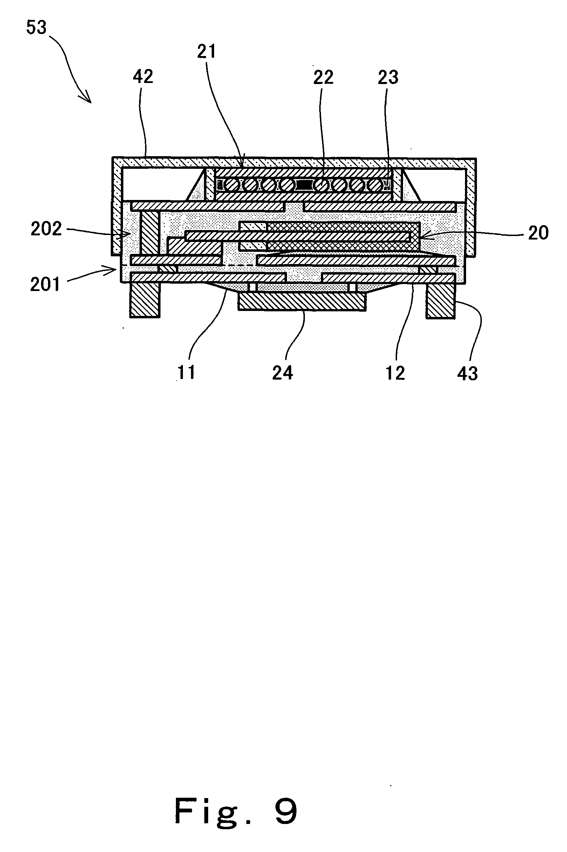

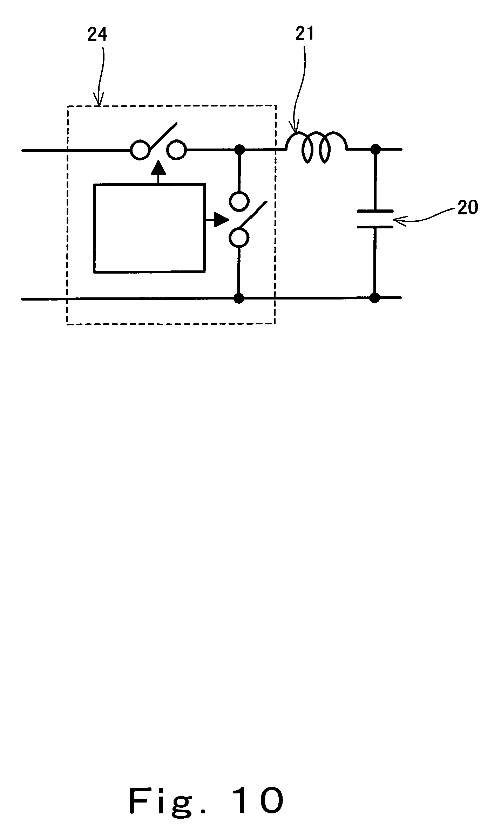

Fig. 8 is a sectional view diagrammatically showing part of a switching power source module. Fig. 9 is a sectional view diagrammatically showing part of a switching power source module having another configuration. Fig. 10 is a typical switching power source module circuit diagram.

In the switching power source modules 53 shown in Figs. 8 and 9, the circuit element 24 is a power semiconductor device having a built-in control circuit; the circuit element 20 is the solid electrolytic capacitor described in the sixth embodiment; and the circuit element 21 is the inductor described in the seventh embodiment. The switching power source module 53 shown in Fig. 9 is composed of a terminal 43 for electrically connecting this switching power source module to another substrate and a case 42 for covering the inductor 21 which case is preferably made of a metal. In Figs. 8 and 9, the electrically insulating material 11, the wirings 12 and the inner via holes 41 are the same as those of the first to seventh embodiments.

Generally, in a switching power source, since a power loss in the circuit element 24 that is a power semiconductor device is prevailing, the heat generated from the circuit element 24 is very large. In the eighth embodiment, the circuit element 20 (i.e., solid electrolytic capacitor) and the circuit element 21 (i.e., inductor) are disposed opposite to the circuit element 24 (i.e., power semiconductor device) as shown in Figs. 8 and 9, thereby releasing the heat generated from the circuit element 24 outwardly from the switching power source module 53.

Fig. 10 is a typical switching power source module circuit diagram. The example shown in Fig. 10 is a circuit diagram of a so-called step-down switching power source circuit. Herein, the circuit element 24 is a power semiconductor device having a built-in control circuit, the circuit element 21 is an inductor, and the circuit element 20 is a solid electrolytic capacitor. For obtaining an output of about 1 W from a switching power source module with a switching frequency of 1 MHz, an inductance of an order of *µ*H is necessary for the circuit element 21, whereas a capacitance of an order of *µ*F is necessary for the circuit element 20. Since such a switching power source module generates, within the circuit, pulse voltage and pulse current which correspond to the switching frequency, noise in pulse form is generated. To reduce the noise in pulse form, the circuit element 24 (i.e., power semiconductor device) needs to be close to the circuit element 20 (i.e., solid electrolytic capacitor) and the circuit element 21 (i.e., inductor) as much as possible. In the switching power source modules 53 shown in Figs. 8 and 9, since the circuit element 24 is disposed close to the circuit elements 20 and 21, the wiring for electrically connecting these circuit elements is the shortest. As a result, the noise in pulse form generated in correspondence with the switching frequency can be effectively restricted. If the circuit element 21 is an inductor having a magnetic substance of low magnetic permeability, a leakage flux from the inductor may adversely affect the semiconductor device and its peripheral circuit. By the shielding effect of the circuit element 20 obtained by interposing the circuit element 20 between the circuit elements 21 and 24 as shown in Figs. 8 and 9, the adverse effect of the leakage flux of the inductor can be suppressed.

While the circuit element 20 is a solid electrolytic capacitor in the present embodiment, the circuit element 20 is not necessarily limited to this but may be a capacitor having high thermal conductivity such as ceramic capacitors.

### (Ninth Embodiment)

The first to eighth embodiments of the invention have been described in the context of mechanisms for releasing heat generated by a heat generating circuit element outwardly from a module with built-in circuit elements through a heat sink member and an electrically insulating material.

Such a module with built-in circuit elements is usually mounted on a mother board (main board). As a method for cooling a heat generating circuit element, there is a method for transferring the heat generated by the circuit element to the mother board through the module with built-in circuit elements. In this case, the heat generating circuit element is effectively cooled by interposing the heat sink member of the module with built-in circuit elements between the heat generating circuit element and the mother board so as to have at least regions which are opposed to the heat generating circuit element and the mother board respectively. By positioning the heat sink member in such a manner, the heat generated from the circuit element can be effectively transferred to the mother board. The configuration of the module with built-in circuit elements in which the heat sink member is arranged as described above is useful for many applications including the first to eighth embodiments of the invention.

### (Tenth Embodiment)

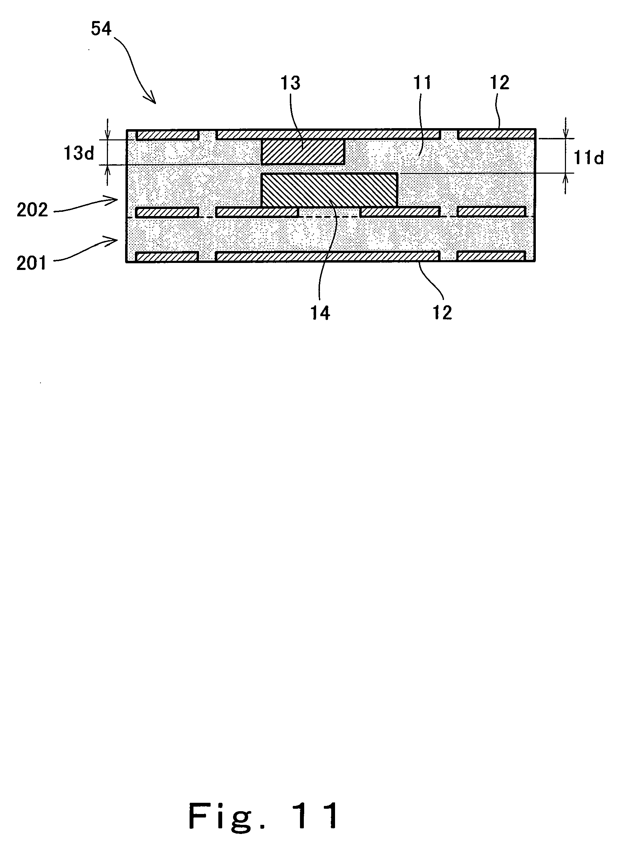

The tenth embodiment of the invention will be described with reference to Figs. 11 to 13.

Fig. 11 is a sectional view diagrammatically showing a module with built-in circuit elements 54 according to this embodiment.

In this embodiment, the following test was conducted, using the module with built-in circuit elements 54 which has the configuration shown in Fig. 11.

In Fig. 11, the circuit element 14 is a semiconductor device the principal surface of which has dimensions of 2 mm × 2 mm. The thickness 11 d of the electrically insulating material 11 between the circuit element 14 and the wirings 12 is 0.4 mm. The thickness 13d of the heat sink member 13, which has high thermal conductivity and is located opposite to the circuit element 14, is 0.3 mm. The thermal conductivities of the electrically insulating material 11 and the heat sink member 13 are 3 (W/m·K) and 400 (W/m·K), respectively. By use of the module with built-in circuit elements 54 having such configuration, the transfer of the heat generated from the circuit element 14 was checked while operating the circuit element 14. Since the dissipation of the heat of the circuit element 14 was limited to dissipation from the upper face of the module with built-in circuit elements 54, the upper face (the face close to the heat sink member 13) of the module with built-in circuit elements 54 was cooled.

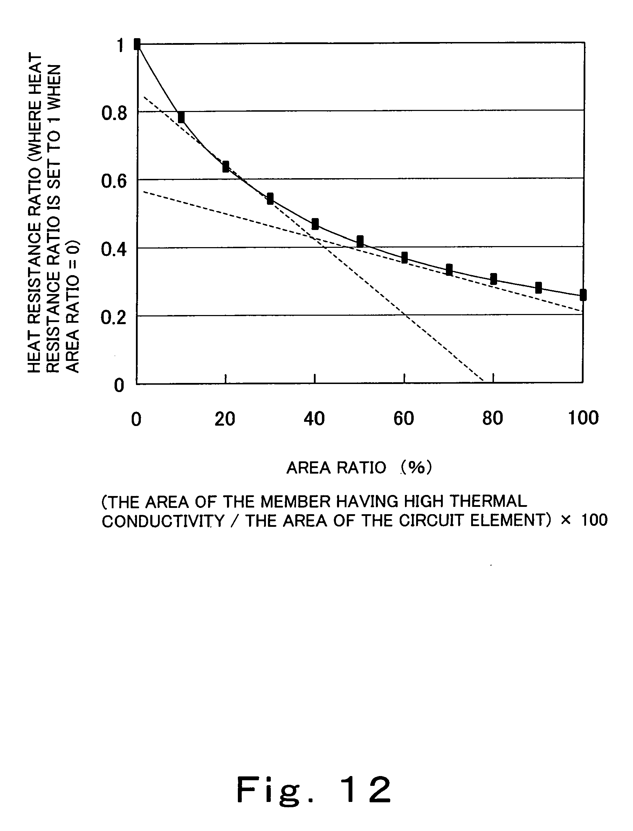

Fig. 12 shows a first result obtained from the above test. Specifically, Fig. 12 is a diagram showing the relationship between the ratio of the area of a portion where the circuit element 14 and the heat sink member 13 are opposed to each other to the area of the principal surface of the circuit element 14 and the heat resistance ratio when heat is transmitted from the circuit element 14 to the heat sink member 13. The area ratio (%) is plotted on the abscissa and the heat resistance ratio is plotted on the ordinate.

As clearly indicated by the characteristic curve of Fig. 12, the heat resistance decreases, as the area of an opposed portion of a principal surface of the heat sink member 13 having high thermo conductivity increases. Herein, the opposed portion of the member 13 is located opposite to the principal surface of the circuit element 14. In the vicinity of an area ratio of 40%, an inflection point exists on the characteristic curve. More specifically, it has been found that the heat of the circuit element 14 can be stably, effectively released outward by making the area of the opposed portion of the principal surface of the heat sink member 13 having high thermal conductivity be 40% or more of the area of the principal surface of the circuit element 14.

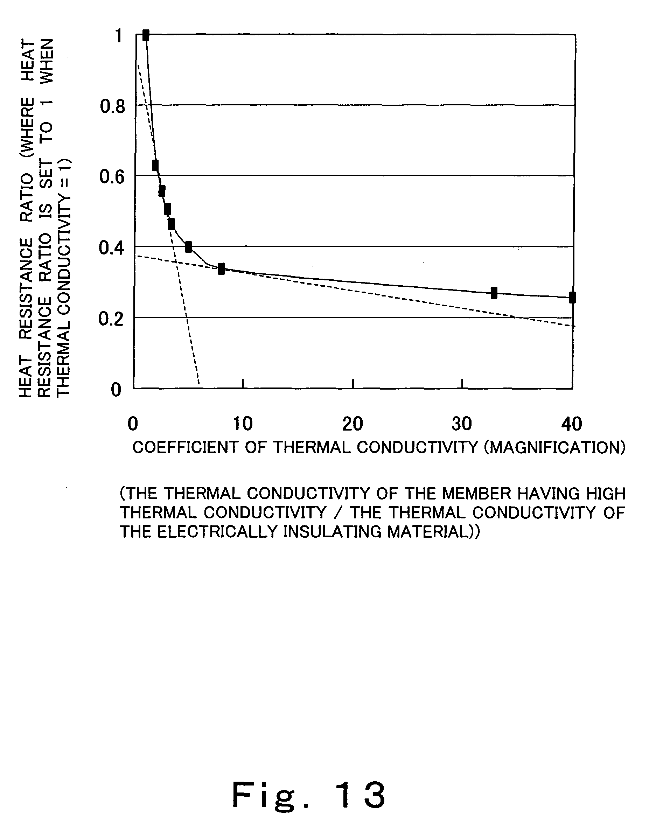

Fig. 13 shows a second effect obtained from the above test. Specifically, Fig. 13 is a diagram showing the relationship between the ratio of the thermal conductivity of the electrically insulating material 11 to the thermal conductivity of the heat sink member 13 and the heat resistance ratio when heat is transmitted from the circuit element 14 to the heat sink member 13, in a case where the heat sink member 13 of high thermal conductivity and the circuit element 14, which have the same area, are opposed to each other. The coefficient of thermal conductivity (represented by magnification) is plotted on the abscissa whereas the heat resistance ratio is plotted on the ordinate.

As clearly indicated by the characteristic curve of Fig. 13, the heat resistance decreases, as the thermal conductivity coefficient of the heat sink member 13 having high thermal conductivity increases. In the vicinity of a thermal conductivity coefficient of 3, an inflection point exists on the characteristic curve. More specifically, it has been found that the heat of the circuit element 14 can be stably, effectively released outward by making the thermal conductivity coefficient of the heat sink member 13 having high thermal conductivity be three times or more that of the electrically insulating material 11.

Although a module with built-in circuit elements has been explained by way of examples in the foregoing description, the invention can be equally implemented by or applied to, for instance, a printed wiring board with built-in circuit elements or devices for use in other applications.

Numerous modifications and alternative embodiments of the invention will be apparent to those skilled in the art in view of the foregoing description. Accordingly, the description is to be construed as illustrative only, and is provided for the purpose of teaching those skilled in the art the best mode of carrying out the invention. The details of the structure and/or function maybe varied substantially without departing from the spirit of the invention and all modifications which come within the scope of the appended claims are reserved.

### Industrial Applicability

The module with built-in circuit elements of the invention is easy to manufacture and has no disincentives to miniaturization. It uses an electrically insulating material of the resin group capable of effective outward dissipation of heat generated by a circuit element.

## Claims

1. A module with built-in circuit elements,
wherein a plurality of substantially two-dimensionally formed wirings are stacked with an electrically insulating material interposed therebetween; said electrically insulating material is made of a mixture containing at least a filler and an electrically insulating resin; and one or more circuit elements are electrically connected to the wirings and at least part of the circuit elements is embedded in the electrically insulating material; and
wherein a heat sink member having higher thermal conductivity than that of the electrically insulating material is included, and the heat sink member and at least high heat generating circuit element among the circuit elements overlap each other when viewed in a laminating direction of the wirings, the high heat generating circuit element rising to higher temperature than other components of the module, while the module is in use.

2. The module with built-in circuit elements according to claim 1,
wherein the heat sink member and the high heat generating circuit element are opposed to each other in the laminating direction of the wirings.

3. The module with built-in circuit elements according to claim 1 or 2,
wherein the heat sink member is disposed on a surface of the electrically insulating material.

4. The module with built-in circuit elements according to claim 3,
wherein the area of the heat sink member is larger than that of the high heat generating circuit element when viewed in the laminating direction of the wirings.

5. The module with built-in circuit elements according to claim 1 or 2,
wherein the high heat generating circuit element is disposed on a surface of the electrically insulating material.

6. The module with built-in circuit elements according to claim 1,
wherein the heat sink member is electrically connected to the wirings.

7. The module with built-in circuit elements according to claim 6,
wherein an electrically conducting member for electrically connecting the plurality of wirings to one another is disposed close to the electrically insulating material; and
which has a portion where the electrically conducting member and the heat sink member are heat-conductively connected.

8. The module with built-in circuit elements according to claim 7,
wherein the electrically conducting member is a through hole.

9. The module with built-in circuit elements according to claim 7,
wherein the electrically conducting member is an inner via hole.

10. The module with built-in circuit elements according to claim 6,
wherein the heat sink member is in the form of a chip part.

11. The module with built-in circuit elements according to claim 10,
wherein the heat sink member contains a metal as a chief component.

12. The module with built-in circuit elements according to claim 10,
wherein the heat sink member contains ceramics as a chief component.

13. The module with built-in circuit elements according to claim 1,
wherein the thermal conductivity of the heat sink member is not less than three times that of the electrically insulating material.

14. The module with built-in circuit elements according to claim 1,
wherein the high heat generating circuit element and the heat sink member are disposed such that the area of a portion where they overlap each other when viewed in the laminating direction of the wirings is 40% or more of the area of the high heat generating circuit element when viewed in the laminating direction of the wirings.

15. The module with built-in circuit elements according to claim 1,
wherein the distance between the high heat generating circuit element and the heat sink member exceeds 0 mm and is 0.5 mm or less.

16. The module with built-in circuit elements according to claim 1,
wherein the high heat generating circuit element and the heat sink member are in close contact with each other through at least the electrically insulating material.

17. The module with built-in circuit elements according to claim 16,
wherein at least one of the wirings is further located between the high heat generating circuit element and the heat sink member.

18. The module with built-in circuit elements according to claim 1,
wherein the heat sink member is thicker than the wirings.

19. The module with built-in circuit elements according to claim 18,
wherein the thickness of the heat sink member is 0.1 mm or more and 1.0 mm or less.

20. The module with built-in circuit elements according to claim 1,
wherein the heat sink member is a heat sink circuit element, which is among said circuit elements and has higher thermal conductivity than the electrically insulating material; and
wherein said heat sink circuit element and the high heat generating circuit element among the circuit elements overlap each other when viewed in a laminating direction of the wirings, the high heat generating circuit element rising to higher temperature than other components of the module, while the module is in use.

21. The module with built-in circuit elements according to claim 20,
wherein the heat sink circuit element and the high heat generating circuit element are opposed to each other when viewed in the laminating direction of the wirings.

22. The module with built-in circuit elements according to claim 20 or 21,
wherein the heat sink circuit element is disposed on a surface of the electrically insulating material.

23. The module with built-in circuit elements according to claim 22,
wherein the area of the heat sink circuit element is larger than that of the high heat generating circuit element when viewed in the laminating direction of the wirings.

24. The module with built-in circuit elements according to claim 20 or 21,
wherein the high heat generating circuit element is disposed on a surface of the electrically insulating material.

25. The module with built-in circuit elements according to claim 20,
wherein the heat sink circuit element is a resistor.

26. The module with built-in circuit elements according to claim 20,
wherein the heat sink circuit element is a capacitor.

27. The module with built-in circuit elements according to claim 20,
wherein the heat sink circuit element is an inductor.

28. The module with built-in circuit elements according to claim 20,
wherein the heat sink circuit element is a laminated body composed of a capacitor and an inductor.

29. The module with built-in circuit elements according to claim 28,
wherein the laminated body is disposed such that the capacitor is located in the vicinity of the high heat generating circuit element.

30. The module with built-in circuit elements according to claim 26 or 28,
wherein the capacitor is a ceramic capacitor.

31. The module with built-in circuit elements according to claim 26 or 28,
wherein the capacitor is a solid electrolytic capacitor.

32. The module with built-in circuit elements according to claim 27 or 28,
wherein the inductor has a laminated structure composed of windings and a magnetic substance and takes the form of a thin sheet.

33. The module with built-in circuit elements according to claim 27 or 28,
wherein the inductor has a laminated structure composed of windings and a magnetic substance, and the windings are sheet-like coils formed by plating.

34. The module with built-in circuit elements according to claim 27 or 28,
wherein the inductor has a laminated structure composed of windings and a magnetic substance and the magnetic substance comprises at least a thin metallic body.

35. The module with built-in circuit elements according to claim 20,
wherein the thermal conductivity of the heat sink circuit element is not less than three times that of the electrically insulating material.

36. The module with built-in circuit elements according to claim 20,
wherein the high heat generating circuit element and the heat sink circuit element overlap each other such that the overlapping area when viewed in the laminating direction of the wirings is 40% or more of the area of the high heat generating circuit element when viewed in the laminating direction of the wirings.

37. The module with built-in circuit elements according to claim 20,
wherein the distance between the high heat generating circuit element and the heat sink circuit element exceeds 0 mm and is 0.5 mm or less.

38. The module with built-in circuit elements according to claim 20,
wherein the high heat generating circuit element is in close contact with the heat sink circuit element through at least the electrically insulating material.

39. The module with built-in circuit elements according to claim 38,
wherein at least one of the wirings is further located between the high heat generating circuit element and the heat sink circuit element.

40. The module with built-in circuit elements according to claim 20,
wherein the heat sink circuit element is thicker than the wirings.

41. The module with built-in circuit elements according to claim 40,
wherein the thickness of the heat sink circuit element is 0.1 mm or more and 1.0 mm or less.
